# EUROPÄISCHE PATENTANMELDUNG

(11) **EP 2 544 228 A2**
(43) Veröffentlichungstag der Anmeldung: **09.01.2013**
(21) Anmeldenummer: 12168171.2
(22) Anmeldetag: 16.05.2012
(51) Int. Cl.: H01L 23/18, H01L 25/07, H01L 23/498

(54) **Leistungselektronisches System mit einer Kühleinrichtung**

(30) Priorität: 07.07.2011 DE 102011078811
(71) Anmelder: SEMIKRON Elektronik GmbH & Co. KG, 90431 Nürnberg (DE)
(72) Erfinder: Besendörfer, Kurt-Georg, 90556 Cadolzburg (DE); Erdner, Nadja, 91227 Leinburg (DE); Steger, Jürgen, 91355 Hiltpoltstein (DE)

(57) **Zusammenfassung**

Die Anmeldung betrifft ein Leistungselektronisches System und ein zugehöriges Herstellungsverfahren mit einer Kühleinrichtung, mit einer Mehrzahl von Submodulen, jedes mit einem ersten flächigen Isolierstoffkörper, genau einer hiermit stoffschlüssigen verbundenen ersten Leiterbahnen, genau einem auf dieser Leiterbahn angeordneten Leistungsschalter, mindestens einer internen Verbindungseinrichtung aus einer alternierenden Schichtfolge mindestens einer elektrisch leitenden und mindestens einer elektrisch isolierenden Folien, wobei mindestens eine elektrisch leitende Schicht mindestens eine zweite Leiterbahn ausbildet und mit externen Anschlusselementen. Die Submodule sind hierbei stoff- oder kraftschlüssig und voneinander beabstandet mit ihrer ersten Hauptfläche auf der Kühleinrichtung angeordnet. Mindestens eine zweite Leiterbahn bedeckt erste Leiterbahnen zweier Submodule zumindest teilweise, verbindet diese elektrisch miteinander und überdeckt einen Zwischenraum zwischen den Submodulen.

## Beschreibung

Die Erfindung beschreibt ein leistungselektronisches System, vorzugsweise zur Ausbildung einer damit realisierten Schaltungsanordnung in Form eines Stromrichters, beispielhaft eines Drei-Phasen-Wechselrichters. Derartige Systeme sind beispielhaft als Leistungshalbleitermodule mit Grundplatte oder als Anordnungen eines Leistungshalbleitermoduls ohne Grundplatte mit einer Kühleinrichtung bekannt.

Aus der DE 10 2009 045 181 A1 sind derartige leistungselektronische System bekannt, die hier aus einem Gleich- und einem Wechselrichter in einem gemeinsamen Gehäuse aufgebaut sind. Um unterschiedlichen Anforderungen gerecht zu werden, weist dieses System zwei Substrate auf, die jeweils aus einem Isolierstoffkörper mit Metallkaschierungen auf beiden Hauptflächen ausgebildet sind. Die jeweilige dem Inneren des Systems zugewandte Seite des Substrats weist hier eine Strukturierung der Metallkaschierung auf, die somit eine Mehrzahl von Leiterbahnen ausbildet.

Eine grundlegende Anforderung an alle gattungsgemäßen leistungselektronischen Systeme ist es die Wärme, die aus der Verlustleistung der Leistungshalbleiterbauelemente resultiert, aus dem System auf oder über die Kühleinrichtung abzuführen. Hierbei ist noch zu berücksichtigen, dass die Systeme im Betrieb zyklischen Temperaturänderungen unterworfen sind. Diese Temperarturschwankungen beanspruchen die Verbindungen verschiedener Komponenten des leistungselektronischen Systems zueinander insbesondere, wenn diese unterschiedliche thermische Ausdehnungskoeffizienten aufweisen.

Ziel allfälliger Bemühungen in der Konstruktion derartiger leistungselektronsicher Systeme ist es daher thermisch bedingte mechanische Belastungen zu kompensieren und damit die Dauerhaltbarkeit und alternativ oder bevorzugt gleichzeitig die thermische Belastbarkeit zu steigern. Aus der DE 10 2006 011 995 A1 ist es hierfür bekannt die Grundplatte eines Leistungshalbleitermoduls auf verschiedene Arten zu segmentieren, zum Teil auch vollständig zu unterbrechen, um hiermit die Anbindung an eine weitere Kühleinrichtung zu verbessern. Die DE 197 07 514 A1 schlägt zu einer Segmentierung zusätzlich vor die einzelnen Grundplattenabschnitte mit einer Vorbiegung zu versehen.

Der Erfindung liegt somit die Aufgabe zugrunde ein leistungselektronisches System vorzustellen, das eine bezüglich der thermischen Ankopplung und der mechanischen Dauerhaltbarkeit verbesserte Verbindung der Leistungshalbleiterbauelement zu einer Kühleinrichtung aufweist.

Die Aufgabe wird erfindungsgemäß gelöst, durch ein leistungselektronisches System mit den Merkmalen des Anspruchs 1, sowie durch Herstellungsverfahren für ein leistungselektronisches System mit den Merkmalen der Ansprüche 9 und 11. Bevorzugte Ausführungsformen sind in den jeweiligen abhängigen Ansprüchen beschrieben.

Das vorgestellte leistungselektronische System kann ausgebildet sein als ein Leistungshalbleitermodul mit einer Grundplatte, wobei diese Grundplatte die Funktion der Kühleinrichtung übernimmt und mit einer weiteren, meist effizienteren, Kühleinrichtung verbindbar ist. Diesbezüglich entspricht dies dem vielfältig bekannten Aufbau eines Leistungshalbleitermoduls mit externen Anschlusselementen, die in einem elektrisch isolierenden Gehäuse angeordneten sind und die Last- und Hilfsanschlüsse ausbilden.

Ebenso kann das leistungselektronische System ausgebildet sein als ein grundplattenloses Leistungshalbleitermodul in Verbindung mit einer Kühleinrichtung. Ein derartiges Leistungshalbleitermodul weist ebenso ein Gehäuse und externe Anschlusselemente oben genannter Funktionalität auf.

Weiterhin kann das leistungselektronische System als ein Subsystem zum Aufbau einer größeren Einheit ausgebildet sein. Hierbei weist das System bevorzugt kein eigenes Gehäuse auf, wie es von den vorgenannten Leistungshalbleitermodulen bekannt ist. Die externen Anschlusselemente dienen hier entweder der internen Verbindung innerhalb der größeren Einheit oder auch zu deren externer Verbindung.

Die vorgenannten externen Anschlusselemente können hierbei auf verschiede Weise ausgebildet sein, wobei in einem leistungselektronischen System nicht nur eine dieser Ausgestaltungen vorgesehen sein kann.

Jegliche Ausgestaltung des erfindungsgemäßen leistungselektronischen Systems weist eine Mehrzahl von ersten flächigen Isolierstoffkörpern, die stoff- oder kraftschlüssig und voneinander beabstandet mit ihrer jeweiligen ersten Hauptfläche auf der Kühleinrichtung angeordnet sind. Diese vorzugsweise aus einem keramischen Werkstoff bestehenden Isolierstoffkörper dienen der elektrischen Isolation von Leistungsschaltern des leistungselektronischen Systems von dessen Kühlreinrichtung.

Diese ersten Isolierstoffkörper sind jeweils Teil eines Submoduls, das weiterhin genau eine erste Leiterbahn aufweist, die erfindungsgemäß auf der zweiten Hauptfläche des ersten Isolierstoffkörper angeordnet und stoffschlüssig damit verbunden ist. Die zweite Hauptfläche ist hierbei der ersten Hauptfläche gegenüberliegend angeordnet, wodurch die jeweiligen ersten Leiterbahnen auf der der Kühlreinrichtung abgewandten Seite der zugeordneten ersten Isolierstoffkörper angeordnet sind.

Weiterhin weist ein Submodul genau einen Leistungsschalter auf, der in verschiedenen bevorzugten Ausprägungen ausgestaltet sein:
- Ein Leistungsschalter kann als genau eine Leistungsdiode oder als genau ein Leistungstransistor oder als genau ein Leistungstransistor mit intrinsisch ausgebildeter antiparallel geschalteter Leistungsdiode ausgebildet sein.
- Ein Leistungsschalter kann als genau ein Leistungstransistor mit genau einer antiparallel geschalteten Leistungsdiode ausgebildet sein.
- Ein Leistungsschalter kann als mindestens ein Leistungstransistor mit mindestens einer antiparallel geschalteten Leistungsdiode ausgebildet sein, wobei hierbei mindestens drei Leistungshalbleiterbauelemente diesen Leistungsschalter ausbilden.

Durch diese Ausbildung eines Submoduls mit genau einem Leistungsschalter auf einem eigenen ersten Isolierstoffkörper kann die im Leistungsschalter erzeugte Verlustleistung sehr effizient zur Kühleinrichtung hin abgeführt werden.

Weiterhin weist das erfindungsgemäße leistungselektronische System mindestens einer internen Verbindungseinrichtung aus einer alternierenden Schichtfolge mindestens einer elektrisch leitenden und mindestens einer elektrisch isolierenden Folie auf, wobei mindestens eine elektrisch leitende Schicht mindestens eine zweite Leiterbahn ausbildet. Hierbei kann mindestens eine elektrisch leitende Schicht der internen Verbindungseinrichtung in sich strukturiert sein und eine Mehrzahl zweiter Leiterbahnen ausbilden. Ebenso können Durchkontaktierung durch isolierende Schichten zur elektrischen Verbindung leitender Schichten vorgesehen sein.

Erfindungsgemäß überdeckt mindestens eine zweite Leiterbahn als Teil der internen Verbindungseinrichtung mindestens einen Zwischenraum zwischen zwei Submodulen. Hierzu bedeckt und kontaktiert diese zweite Leiterbahn zumindest teilweise die ersten Leiterbahnen der Submodule und verbindet diese beiden Leiterbahnen somit elektrisch miteinander.

Ein Zwischenraum zwischen den Submodulen wird durch die zweite Leiterbahn zumindest derart überdeckt, dass zwar der gesamte Abstand zwischen den beiden Submodulen überdeckt wird, allerdings nicht zwangsläufig auf der gesamten Breite des einen oder anderen Submoduls.

Zur Sicherstellung der elektrischen Isolation zwischen der zweiten Leiterbahn und der Kühleinrichtung kann es vorteilhaft sein den Zwischenraum zwischen dieser und der Kühleinrichtung durch einen Isolierstoff derart auszufüllen, dass er sich zumindest im Bereich der Überdeckung zwischen den Randbereichen der ersten Isolierstoffkörper bzw. der Submodule erstreckt und jeweils an diese ersten Isolierstoffkörper anschließt. Es kann natürlich aus Gründen der elektrischen Isolation vorteilhaft sein diesen Isolierstoff nicht nur unmittelbar unterhalb der zweiten Leiterbahn sondern auch seitlich hiervon vorzusehen.

Dieser Isolierstoff kann hierbei ausgebildet sein als eine gelartige Flüssigkeit, wie sie vielfältig in Leistungshalbleitermodul beispielhaft zur internen Isolation eingesetzt wird. Diese Ausgestaltung weist den Vorteil eines guten Anschlusses an den entsprechenden Randbereich des ersten Isolierstoffkörpers auf.

Alternativ kann dieser Isolierstoff auch als ein zweiter Isolierstoffkörper, vorteilhaft aus einem komprimierbaren Stoff ausgebildet sein, der sich unter Druck an den entsprechenden Randabschnitt des ersten Isolierstoffkörpers anlegt.

Ebenso ist als Ausgestaltung des Isolierstoffs eine Kombination aus zweitem Isolierstoffkörper, nicht notwendigerweise ausgestaltet als nicht komprimierbarer Stoff, und gelartiger Flüssigkeit in bestimmten Einsatzgebieten vorteilhaft.

Der wesentliche Vorteil der erfindungsgemäßen Ausgestaltung eines leistungselektronischen Systems liegt in der weitgehenden mechanischen Entkopplung der Kühleinrichtung und des jeweiligen Leistungshalbleiterbauelements. Die ersten Leiterbahnen weisen, da sie typischerweise aus Kupfer bestehen, einen ähnlichen oder sogar gleichen Ausdehnungskoeffizienten auf wie die Kühleinrichtung, die typisch aus Aluminium oder Kupfer besteht. Demgegenüber weisen die ersten Isolierstoffkörper und die Leistungshalbleiterbauelemente einen wesentlich kleineren Ausdehnungskoeffizienten auf. Durch die Ausbildung des Substrats bestehend aus ersten Leiterbahnen und einer Mehrzahl voneinander beanstandeter erster Isolierstoffkörper sind im Rahmen thermischer Ausdehnung die Leistungshalbleiterbauelement von der Kühleinrichtung mechanisch weniger starr verbunden als aus dem Stand der Technik bekannt. Hierdurch werden die Verbindungen der jeweiligen Komponenten weniger stark mechanisch belastet und erzielen eine größere Dauerhaltbarkeit. Gleichzeit ist die thermische Ankopplung der Leistungshalbleiterbauelemente zur Kühleinrichtung nicht zuletzt auf Grund der bevorzugten Sinterverbindungen annährend optimal.

Erfindungsgemäß wird ein derartiges leistungselektronisches System mittels folgender wesentlicher Schritte hergestellt:
a) Bereitstellen eines Kühlkörpers;
b) Ausbilden der Submodule aus einem ersten flächigen Isolierstoffkörper, genau einer hiermit stoffschlüssigen verbundenen ersten Leiterbahnen, genau einem auf dieser Leiterbahn angeordneten Leistungsschalter;
c) Stoff- oder kraftschlüssiges Verbinden der Submodule mit der Kühleinrichtung; vorteilhafterweise schließt sich nun direkt das Anordnen des mindestens einen Isolierstoffes an;
d) Ausbilden der mindestens einer internen Verbindungseinrichtung aus einer alternierenden Schichtfolge elektrisch leitender und elektrisch isolierender Folien, wobei mindestens eine elektrisch leitende Schicht mindestens eine zweite Leiterbahn ausbildet;
e) Stoffschlüssiges Verbinden mindestens einen zweiten Leiterbahn mit ersten Leiterbahnen mindestens zweier Submodule derart, dass mindestens eine zweite Leiterbahn einen Zwischenraum zwischen den Submodulen überdeckt.

Vorteilhafterweise werden diese Schritte entweder in der gegeben Reihenfolge, oder in der Reihenfolge a), b), d), c), e) ausgeführt.

Alternativ zu oben genanntem Verfahren und ebenfalls erfindungsgemäß wird ein derartiges leistungselektronisches System mittels folgender wesentlicher Schritte hergestellt:
a) Bereitstellen eines Kühlkörpers;
b) Bereitstellen erster flächigen Isolierstoffkörper und zugeordneter ersten Leiterbahnen als Teile der Submodule;
c) Stoffschlüssiges Verbinden des Kühlkörpers mit den ersten Isolierstoffkörpern;
d) Anordnen der Leistungsschalter auf den jeweiligen Leiterbahnen;
e) Stoffschlüssiges Verbinden der Leistungsschalter mit der zugeordneten Leiterbahn; vorteilhafterweise schließt sich nun direkt das Anordnen des mindestens einen Isolierstoffes an;
f) Ausbilden der mindestens einer internen Verbindungseinrichtung aus einer alternierenden Schichtfolge elektrisch leitender und elektrisch isolierender Folien, wobei mindestens eine elektrisch leitende Schicht mindestens eine zweite Leiterbahn ausbildet;
g) Stoffschlüssiges Verbinden mindestens einen zweiten Leiterbahn mit ersten Leiterbahnen mindestens zweier Submodule derart, dass mindestens eine zweite Leiterbahn einen Zwischenraum zwischen den Submodulen überdeckt.

Vorteilhafterweise werden die Schritte in der genannten Reihenfolge oder die Schritte e) und g) gemeinsam nach dem Schritt f) ausgeführt. Unabhängig hiervon ist es ebenso vorteilhaft während des Schrittes c) gleichzeitig die Isolierstoffkörper mit den zugeordneten ersten Leiterbahn zu verbinden.

Falls der Isolierstoff ausschließlich aus einer gelartigen Flüssigkeit besteht, kann diese in beiden Verfahren auch noch zu einem späteren Zeitpunkt des Herstellungsprozesses angeordnet werden. Es ist nämlich bekannt derartige Flüssigkeiten derart auszubilden, dass sie in einem Zustand geringer Viskosität vorliegen und erst durch thermisches oder anderweitiges Einleiten einer Vernetzung die Viskosität steigt und sich der gelartige Zustand ausbildet.

Grundsätzlich ist es vorteilhaft alle Verbindungen zweier Verbindungspartner des leistungselektronischen Systems mit Ausnahme derjenigen zwischen dem Kühlkörper und den ersten Isolierstoffkörpern als stoffschlüssige Verbindungen auszubilden. Für diese Verbindung zwischen dem Kühlkörper und den ersten Isolierstoffkörpern ist eine kraftschlüssige Verbindung ebenso geeignet wie eine stoffschlüssige.

Eine derartig kraftschlüssige Verbindung entsteht fachüblich durch eine Druckeinleitung auf den ersten Isolierstoffkörper. Der Druck kann hierbei direkt auf den Isolierstoffkörper, über eine erste Leiterbahn oder auch über diese und weitere Komponenten eingeleitet werden.

Als stoffschlüssige Verbindung eignen sich verschiedene Ausgestaltungen von Lotverbindungen, wie auch bevorzugt Sinterverbindungen wegen ihrer hervorragenden mechanischen und thermischen Belastbarkeit, Dauerhaltbarkeit und Stromtragfähigkeit. Zur Ausbildung derartiger Sinterverbindungen ist es fachüblich an den Verbindungsstellen der Verbindungspartner eine Edelmetalloberfläche vorzusehen, zwischen den beiden Verbindungsstellen eine edelmetallhaltige Sinterpaste als Verbindungsmittel anzuordnen, und die Verbindungspartner unter hohem Druck und moderater Temperatur mittels einer Drucksintervorrichtung zu verbinden. In aktuellen Ausbildungen dieser Sintertechnik werden auch mehrere Verbindungen, hier beispielhaft diejenige der Leistungsschalter mit den ersten Leiterbahnen und mit einer internen Verbindungseinrichtung in oben genannter Form, gleichzeitig ausgebildet. Es kann allerdings ebenso vorteilhaft sein andere Kombinationen von Verbindungspartnern für eine gleichzeitige Verbindung auszuwählen.

Die erfinderische Lösung wird an Hand der Ausführungsbeispiele gemäß den Fig. 1 bis 7 weiter erläutert.

Fig. 1 zeigt eine typische Schaltungsanordnung, die mittels eines oder mehrerer erfindungsgemäßer leistungselektronischer Systeme ausbildbar ist.

Fig. 2 bis 4 zeigen Phasen eines ersten erfindungsgemäßen Herstellungsverfahrens.

Fig. 5 bis 7 zeigen Phasen eines zweiten erfindungsgemäßen Herstellungsverfahrens.

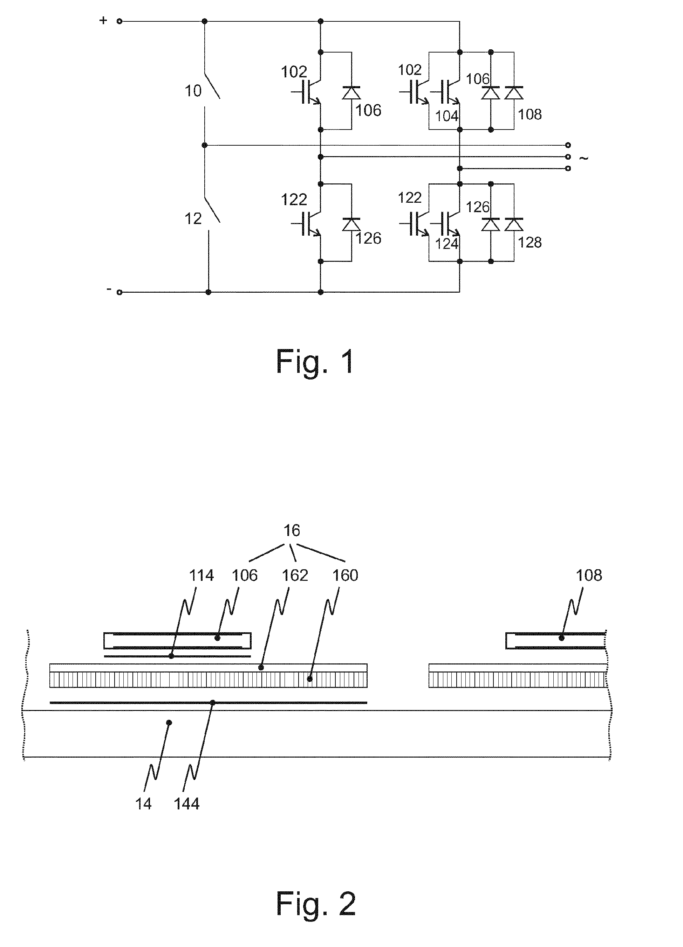

Fig. 1 zeigt eine typische Schaltungsanordnung, eine Drei-Phasen Brückenschaltung, die mittels eines oder mehrerer erfindungsgemäßer leistungselektronischer Systeme ausbildbar ist. Die einzelnen drei Halbbrücken dieser Drei-Phasen Brückenschaltung sind hier unterschiedlich detailliert dargestellt.

Die erste, linke Halbbrückenschaltung zeigt eine allgemeine Darstellung, mit einem ersten, oberen, auch "TOP" genannten, Leistungsschalter 10 und einem zweiten, unteren, auch "BOT", genannten Leistungsschalter 12. Diese Leistungsschalter 10, 12 sind mit einer Gleichspannungsquelle verbunden, während ihre Mittelanzapfung den Wechselspannungsausgang der ersten Phase bildet.

In den weiteren Halbbrückenschaltungen sind verschiedene konkretere Ausgestaltungen dargestellt. Beispielhaft kann ein Leistungsschalter 10, 12 als ein Leistungstransistor 102, 122 mit einer antiparallel geschalteten externen oder intrinsischen Leistungsdiode 106, 126 ausgebildet sein. Ebenso sind eine Mehrzahl dieser Varianten zur Ausbildung eines Leistungsschalters vorsehbar. Beispielhaft sind hier zwei Leistungstransistoren 102, 104, 122, 124 und zwei Leistungsdioden 106, 108, 126, 128 für den oberen 10 und den unteren Leistungsschalter 12 vorgesehen.

Ein erfindungsgemäßes leistungselektronisches System kann nun mindestens eines, aber auch alle drei dieser oben genannten Halbbrückenschaltungen gleichzeitig ausbilden. Grundsätzlich sind auch anderen Schaltungstopologien, wie beispielhaft Gleichspannungsbrücken oder Multilevelbrückenschaltungen mit mehr als zwei in Reihe geschalteten Leistungsschaltern je Brückenschaltung ausbildbar.

Fig. 2 bis 4 zeigen Phasen eines ersten erfindungsgemäßen Herstellungsverfahrens. Fig. 2 zeigt schematisch in einem Ausschnitt eine Phase der Herstellung eines leistungselektronischen Systems, sowie zwei Submodule 16. Dargestellt ist eine Kühleinrichtung 14, zwei erste Isolierstoffkörper 160 jeweils mit einer bereits hierauf angeordneten ersten Leiterbahn 162. Beabstandet davon dargestellt sind jeweils Leistungsdioden 106 als eine mögliche Ausgestaltung der erfindungsgemäß vorgesehenen Leistungsschalter 10, 12. Diese Leistungsdioden 106 werden stoffschlüssig mit der zugeordneten Leiterbahn 162 verbunden, wozu eine Verbindungsschicht 114 vorgesehen ist. Die jeweilige Leistungsdiode 106, allgemeiner der jeweilige Leistungsschalter 10, 12, sowie der erste Isolierstoffkörper 160 mit erster Leiterbahn 162 bilden das Submodul 16 und somit das grundlegende erfinderische Element des leistungselektronischen Systems aus.

Dieses Submodul 16 wird stoffschlüssig mit der Kühleinrichtung 14 mittels einer Verbindungsschicht 144 verbunden. Es kann vorteilhaft sein, erst das Submodul 16 vollständig auszubilden und anschließend einzelne Submodule 16 mit der Kühleinrichtung 14 zu verbinden. Hierbei können die einzelnen Submodule 16 bereits einem ersten elektronischen Test zugeführt werden und nur erfolgreich getestet Submodule 16 werden anschließend weiter verbaut. Falls die Verbindung der Submodule 16 mit der Kühleinrichtung 14 in nicht dargestellter Weise kraftschlüssig erfolgen sollte ist es selbstverständlich sinnvoll diese Verbindung erst zu einem späteren Zeitpunkt im Herstellungsverfahren vorzusehen.

Aus Gründen der Herstellungsökonomie und speziell bei Vorsehen gleichartiger stoffschlüssiger Verbindungen kann es auch vorteilhaft sein die dargestellten Komponenten in einem Herstellungsschritt stoffschlüssig zu verbinden.

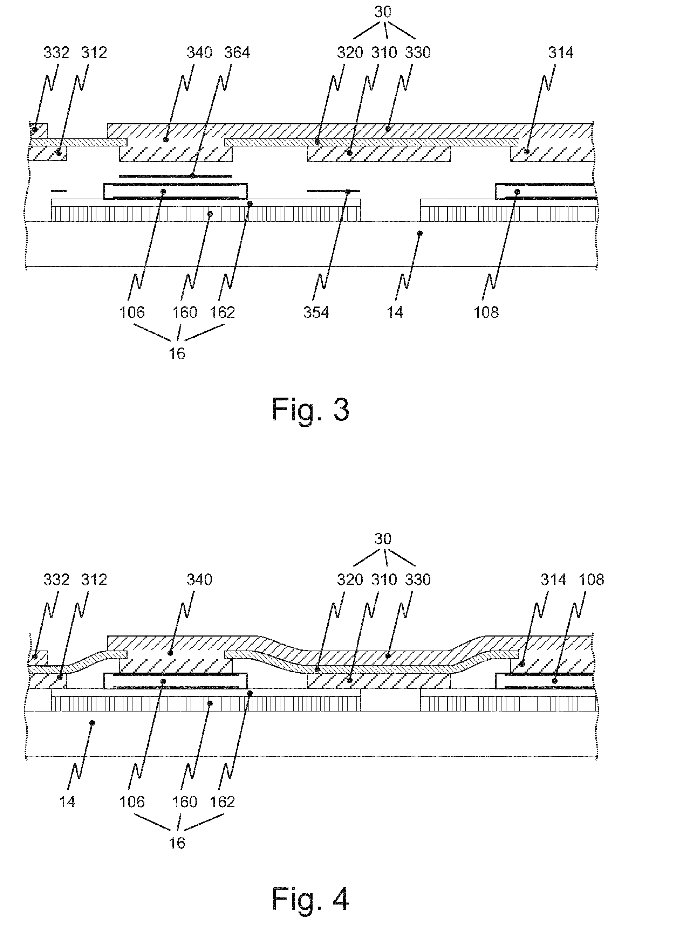

Fig. 3 zeigt die interne Verbindungseinrichtung 30, bestehend aus einer Schichtfolge aus einer in sich strukturierten leitenden 310, 312, 314 einer isolierenden 320 und wiederum einer in sich strukurierten leitenden 330, 332 Folie. Hierbei sind auch Durchkontaktierungen 340, wie sie in verschiedenen Ausgestaltungen bereits aus dem Stand der Technik bekannt sind, vorgesehen, um die schaltungsgerechte interne Verbindung des leistungselektronischen Systems ausbilden zu können. Gerade hierfür sind die einzelnen leitenden Schichten in sich strukturiert und bilden die Mehrzahl von Leiterbahnen aus.

Eine dieser Leiterbahnen bildet eine zweite Leiterbahn 310 zur erfindungsgemäßen Verbindung erster Leiterbahnen 162 von Submodulen 16 miteinander aus. Die Verbindung dieser zweiten Leiterbahnen 310 mit den ersten Leiterbahnen 162 erfolgt hierbei wiederum durch eine stoffschlüssige Verbindung mittels geeignet vorgesehener Verbindungsschichten 354, von denen nur ein dargestellt ist. An diesen Kontaktstellen bedeckt die zweite Leiterbahn 310 die ersten Leiterbahnen 162. In genannter Weise sind leitenden Schichten 314 der internen Verbindungseinrichtung 30 auch mit Kontaktflächen der Leistungsdioden 106, 108, allgemeiner der Leistungsschalter 10, 12, der jeweiligen Submodule 16 verbunden. Diese Kontaktflächen sind hierzu auf der den ersten Isolierstoffkörpern 160 abgewandten Seite der Leistungsdioden 106, 108 vorgesehen.

Fig. 4 zeigt einen Ausschnitt eines erfindungsgemäßen leistungselektronischen Systems nach Anordnung der internen Verbindungseinrichtung 30 zu den Submodulen 16, wobei hier der flexible Ausgestaltung der internen Verbindungseinrichtung 30 durch die alternierende Schichtfolge zweier elektrisch leitender Folien und einer elektrisch isolierenden Folie deutlich wird.

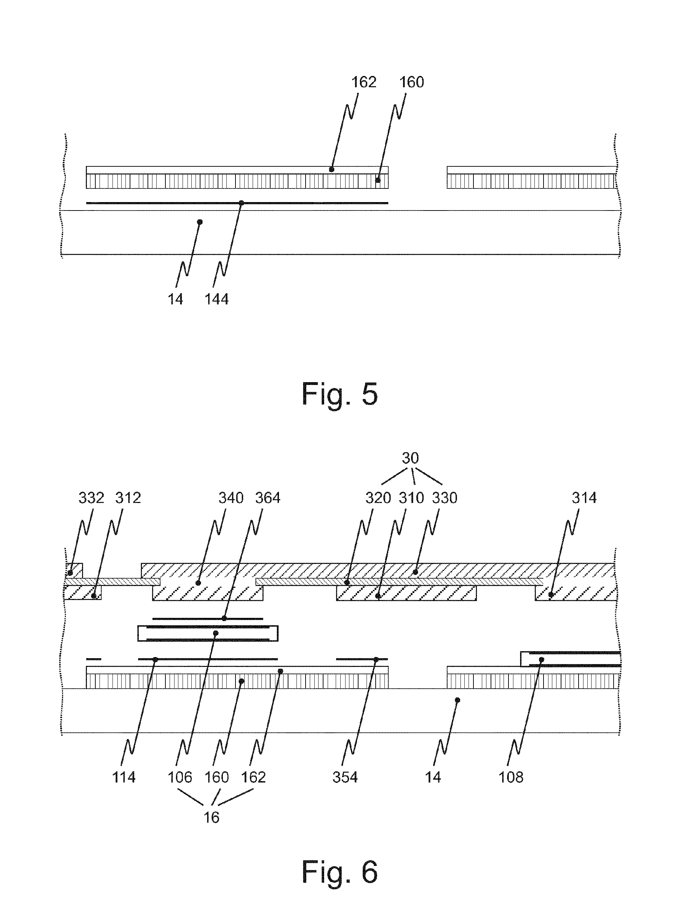

Fig. 5 bis 7 zeigen Phasen eines zweiten erfindungsgemäßen Herstellungsverfahrens. Fig. 5 zeigt hierbei die Verbindung der Kühleinrichtung 14 mit ersten Isolierstoffkörpern 160 und mit ersten Leiterbahnen 162. Vorteilhafterweise werden diese drei Komponenten in einen Herstellungsschritt miteinander verbunden. Alternativ können auch erst die ersten Leiterbahnen 162 mit den ersten Isolierstoffkörpern 160 verbunden werden und anschließend diese mit der Kühleinrichtung 14.

Fig. 6 zeigt eine bereits zu Fig. 3 beschriebene interne Verbindungseinrichtung 30. In vorteilhafter Weise wird diese mit den Leistungsschaltern 10,12 hier wieder in der Ausprägung von Leistungsdioden 106, 108 dargestellt, stoffschlüssig mittels zugeordneter Verbindungsmittel 364 verbunden.

In einem nächsten Schritt wird dieser Verbund aus Leistungsdioden 106, 108 und interner Verbindungseinrichtung 30 mit dem Verbund aus Kühleinrichtung 14, ersten Isolierstoffkörpern 160 und ersten Leiterbahnen 162 stoffschlüssig mittels zugeordneter Verbindungsmittel 354 verbunden.

Alternativ können die interne Verbindungseinrichtung 30 und die Leistungsdioden 106, 108 in einem Herstellungsschritt mit dem Verbund aus Kühleinrichtung 14, ersten Isolierstoffkörpern 160 und ersten Leiterbahnen 162 stoffschlüssig mittels zugeordneter Verbindungsmittel 354, 364 verbunden werden.

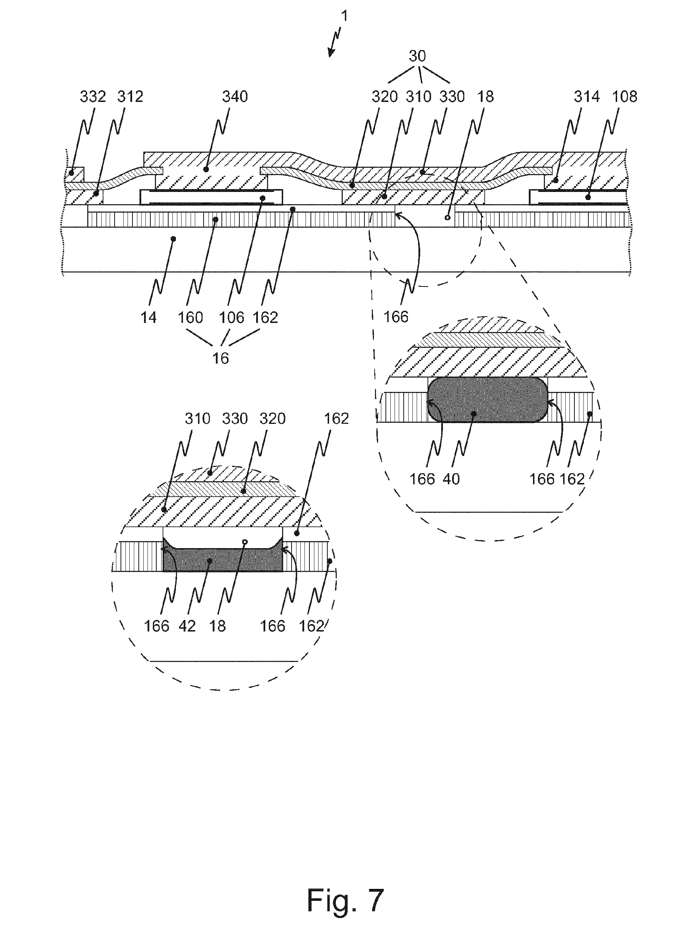

Fig. 7 zeigt einen Ausschnitt eines erfindungsgemäßen, mittels oben genannter Verfahren hergestellten leistungselektronischen Systems mit einer Kühleinrichtung 14, hierauf angeordneten Submodulen 16 und mit einer internen Verbindungseinrichtung 30. Zweite Leiterbahnen 310 ausgebildet durch die Strukturierung einer leitenden Schicht dieser Verbindungseinrichtung 30 verbinden hierbei schaltungsgerecht Submodule 16, konkret deren erste Leiterbahnen 162, miteinander. Die interne Verbindungseinrichtung 30 dienen nicht nur der internen schaltungsgerechten Verbindung des leistungselektronischen Systems sondern kann in ihrem nicht dargestellten weiteren Verlauf selbst externe Anschlusselemente ausbilden oder mit diesen verbunden sein.

Unterhalb dieser zweiten Leiterbahnen 310 und zwischen den Randbereichen 166 der Submodule 16 entsteht somit ein Zwischenraum 18 zwischen dieser zweiten Leiterbahn 310 und der Kühleinrichtung 14. In diesem Zwischenraum 18 ist an notwendigen Stellen ein Isolierstoff 40, 42 vorgesehen, der hier in den Ausschnittsvergrößerungen entweder als gelartige Flüssigkeit 42 oder als ein zweiter komprimierbarer Isolierstoffkörper 40 ausgebildet ist. Selbstverständlich können beide Ausgestaltungen auch kombiniert vorgesehen werden

## Patentansprüche

1. Leistungselektronisches System (1) mit einer Kühleinrichtung (10), mit einer Mehrzahl von Submodulen (16), jedes mit einem ersten flächigen Isolierstoffkörper (160), genau einer hiermit stoffschlüssigen verbundenen ersten Leiterbahnen (162), genau einem auf dieser Leiterbahn (162) angeordneten Leistungsschalter (10, 12),
mindestens einer internen Verbindungseinrichtung (30) aus einer alternierenden Schichtfolge mindestens einer elektrisch leitenden (310, 312, 314, 330, 332) und mindestens einer elektrisch isolierenden (320) Folien, wobei mindestens eine elektrisch leitende Schicht mindestens eine zweite Leiterbahn (310) ausbildet und mit externen Anschlusselementen, wobei
die Submodule (16) stoff- oder kraftschlüssig und voneinander beabstandet mit ihrer ersten Hauptfläche auf der Kühleinrichtung (14) angeordnet sind,
mindestens eine zweite Leiterbahn (310) erste Leiterbahnen (162) zweier Submodule (16) zumindest teilweise bedeckt, diese elektrisch miteinander verbindet und einen Zwischenraum (18) zwischen den Submodulen (16) überdeckt.

2. Leistungselektronisches System nach Anspruch 1, wobei
ein Leistungsschalter (10, 12) als genau eine Leistungsdiode, als genau ein Leistungstransistor oder als genau ein Leistungstransistor mit intrinsisch ausgebildeter antiparallel geschalteter Leistungsdiode ausgebildet ist.

3. Leistungselektronisches System nach Anspruch 1, wobei
ein Leistungsschalter (10, 12) als genau ein Leistungstransistor (106, 126) mit genau einer antiparallel geschalteten Leistungsdiode (102, 122) ausgebildet ist.

4. Leistungselektronisches System nach Anspruch 1, wobei
ein Leistungsschalter (10, 12) als mindestens ein Leistungstransistor (102, 104, 122, 124) mit mindestens einer antiparallel geschalteten Leistungsdiode (106, 108, 126, 128) ausgebildet ist.

5. Leistungselektronisches System nach Anspruch 1, wobei
die ersten Isolierstoffkörper (160) aus einem keramischen Werkstoff bestehen.

6. Leistungselektronisches System nach Anspruch 1, wobei
mindestens eine elektrisch leitende Schicht der internen Verbindungseinrichtung in sich strukturiert ist und eine Mehrzahl zweiter Leiterbahnen (310, 312, 314, 330, 332) ausbildet.

7. Leistungselektronisches System nach Anspruch 1, wobei
mindestens ein durch eine zweite Leiterbahn (310) überdeckter Zwischenraum (18) zwischen zwei Submodulen (16) durch einen Isolierstoff (40, 42) derart ausgefüllt ist, dass er sich zumindest im Bereich der Überdeckung zwischen den Randbereichen (166) der Submodule (16) erstreckt und jeweils an diese Submodule (16) anschließend ausgebildet ist.

8. Leistungselektronisches System nach Anspruch 7, wobei
der Isolierstoff als ein zweiter Isolierstoffkörper (40) oder als eine gelartige Flüssigkeit (42) oder als Kombination dieser ausgebildet ist.

9. Herstellungsverfahren für ein leistungselektronisches System mit einer Kühleinrichtung (10), einer Mehrzahl von Submodulen (16) mindestens einer internen Verbindungseinrichtung (30) und externen Anschlusselementen, bestehend aus den folgenden Arbeitsschritten
a) Bereitstellen eines Kühlkörpers (14);
b) Ausbilden der Submodule (16) aus einem ersten flächigen Isolierstoffkörper (160), genau einer hiermit stoffschlüssigen verbundenen ersten Leiterbahnen (162), genau einem auf dieser Leiterbahn (162) angeordneten Leistungsschalter (10, 12);
c) Stoff- oder kraftschlüssiges Verbinden der Submodule (16) mit der Kühleinrichtung (14);
d) Ausbilden der mindestens einer internen Verbindungseinrichtung (30) aus einer alternierenden Schichtfolge elektrisch leitender und elektrisch isolierender Folien, wobei mindestens eine elektrisch leitende Schicht mindestens eine zweite Leiterbahn (310) bildet;
e) Stoffschlüssiges Verbinden mindestens einen zweiten Leiterbahn (310) mit ersten Leiterbahnen (162) mindestens zweier Submodule (16) derart, dass mindestens eine zweite Leiterbahn (310) einen Zwischenraum (18) zwischen den Submodulen (16) überdeckt.

10. Herstellungsverfahren nach Anspruch 9, wobei
das Herstellungsverfahren in der genannten Reihenfolge oder in der Reihenfolge a), b), d), c), e) ausgeführt wird.

11. Herstellungsverfahren für ein leistungselektronisches System mit einer Kühleinrichtung (10), einer Mehrzahl von Submodulen (16) mindestens einer internen Verbindungseinrichtung (30) und externen Anschlusselementen, bestehend aus den folgenden Arbeitsschritten
a) Bereitstellen eines Kühlkörpers (14);
b) Bereitstellen erster flächigen Isolierstoffkörper (160) und jeweils einer zugeordneten ersten Leiterbahn (162) als Teile der Submodule (16);
c) Stoffschlüssiges Verbinden des Kühlkörpers (14) mit den ersten Isolierstoffkörpern (160);
d) Anordnen der Leistungsschalter (10,12) auf den jeweiligen Leiterbahnen (162);
e) Stoffschlüssiges Verbinden der Leistungsschalter (10, 12) mit der zugeordneten Leiterbahn (162);
f) Ausbilden der mindestens einer internen Verbindungseinrichtung (30) aus einer alternierenden Schichtfolge elektrisch leitender und elektrisch isolierender Folien, wobei mindestens eine elektrisch leitende Schicht mindestens eine zweite Leiterbahn (310) bildet;
g) Stoffschlüssiges Verbinden mindestens einen zweiten Leiterbahn (310) mit ersten Leiterbahnen (162) mindestens zweier Submodule (16) derart, dass mindestens eine zweite Leiterbahn (310) einen Zwischenraum zwischen den Submodulen (16) überdeckt.

12. Herstellungsverfahren nach Anspruch 11, wobei
das Herstellungsverfahren in der genannten Reihenfolge oder die Schritte e) und g) gemeinsam nach dem Schritt f) ausgeführt werden.

13. Herstellungsverfahren nach Anspruch 11, wobei
während des Schrittes c) gelichzeitig die ersten Isolierstoffkörper (160) mit den zugeordneten ersten Leiterbahn (162) verbunden werden.

14. Herstellungsverfahren nach einem der Ansprüche 9 bis 12, wobei ein Isolierstoff (40, 42) zwischen mindestens zwei Submodulen (16) angeordnet wird.

15. Herstellungsverfahren nach einem der Ansprüche 9 bis 12, wobei zum Ausbilden stoffschlüssiger Verbindungen zwischen zwei Verbindungspartner eine Sinterpaste als Verbindungsmittel (114, 144, 354, 364) vorgesehen ist und die Verbindung jeweils mittels einer Drucksintervorrichtung ausgebildet wird.
